# EUROPÄISCHE PATENTANMELDUNG

(11) **EP 3 409 812 A1**
(43) Veröffentlichungstag der Anmeldung: **05.12.2018**
(21) Anmeldenummer: 17173668.9
(22) Anmeldetag: 31.05.2017
(51) Int. Cl.: C23C 16/448, C23C 16/455, B01B 1/00

(54) **GASVERSORGUNGSSYSTEM UND GASVERSORGUNGSVERFAHREN**

(71) Anmelder: Meyer Burger (Germany) AG, 09337 Hohenstein-Ernstthal (DE)
(72) Erfinder: Löwel, Oliver, 09337 Hohenstein-Ernstthal (DE); Fröhner, Marco, 09376 Oelsnitz (DE); Böddicker, Alexander, 09126 Chemnitz (DE)
(74) Vertreter: Kailuweit & Uhlemann Patentanwälte Partnerschaft mbB

(57) **Zusammenfassung**

Die Erfindung betrifft ein Gasversorgungssystem mit einem Massenflusscontroller für Flüssigkeiten, Flüssigkeitsleitungen, einem Verdampfer zur Überführung eines Fluides von dem flüssigen in den gasförmigen Aggregatzustand insbesondere bei subatmosphärischen Druck, Gasleitungen, sowie einer Mischvorrichtung zur Mischung des Fluides mit einem Trägergas sowie ein entsprechendes Gasversorgungsverfahren. Es ist die Aufgabe der vorliegenden Erfindung, ein Gasversorgungssystem vorzuschlagen, das lange Betriebszeiten zwischen Wartungsarbeiten sowie niedrige Wartungskosten ermöglicht. Die Aufgabe wird durch ein Gasversorgungssystem gelöst, bei welchem das Gasversorgungssystem in der Fluidflussrichtung zunächst den Massenflusscontroller, dann eine erste beheizbare Gasleitung, anschließend einen Verdampfer und die Mischvorrichtung aufweist.

## Beschreibung

Die vorliegende Erfindung betrifft ein Gasversorgungssystem mit einem Massenflusscontroller für Flüssigkeiten, Flüssigkeitsleitungen, einem Verdampfer zur Überführung eines Fluides von dem flüssigen in den gasförmigen Aggregatzustand, insbesondere bei subatmosphärischen Druck, Gasleitungen, sowie einer Mischvorrichtung zur Mischung des Fluides mit einem Trägergas. Des Weiteren betrifft die Erfindung auch ein Gasversorgungsverfahren eines mit einem Trägergas gemischten verdampften Fluides, bei dem der Fluss des flüssigen Fluides von einem Massenflusscontroller für Flüssigkeiten geregelt, dass Fluid verdampft und mit einem Trägergas gemischt wird.

Fluide, beispielsweise flüssige Precursoren für chemische Gasphasenabscheidungen, müssen vor ihrer Verwendung in einer Bearbeitungskammer einer Bearbeitungsanlage oftmals zunächst in einen gasförmigen bzw. dampfförmigen Zustand überführt werden. Die Fluide werden oftmals nicht in reiner Form in die Bearbeitungskammer eingeleitet, sondern zunächst mit einem Trägergas verdünnt.

Die Verdampfung und die Vermischung mit einem Trägergas sind im Stand der Technik teilweise miteinander gekoppelt. Beispielsweise in sogenannten "Bubblern" wird das gasförmige Trägergas in ein flüssiges Fluid eingeleitet, wodurch Blasen des Trägergases in dem Fluid aufsteigen. Dabei wird gleichzeitig Dampf des Fluides in dem Trägergas angereichert. Der Bubbler kann auch beheizt sein, wodurch der Dampfdruck des Fluides in dem Bubbler steigt. Nachteilig an den Bubblern sind eine begrenzte Prozesskontrolle, da das Gasgemisch von Fluid und Trägergas nur indirekt, zum Beispiel über einen Trägergasfluss und eine Bubbler-Temperatur, kontrolliert werden können, wobei beispielsweise zeitliche Effekte nach Schaltvorgängen des Gasflusses nicht immer ausreichend genau beherrschbar sind. DE 10 2014 220 512 A1 beschreibt ein modular aufgebautes Versorgungssystem, dass Bubbler enthalten kann. Für Gasgemische, bei denen die Gasleitungen beheizt werden müssen, sind solche integrierten Gaskabinette begrenzt geeignet, da sie schwierig beheizbar sind.

Im Stand der Technik sind Flüssigkeits-Dosiersysteme mit geregelter Verdampfung bekannt, bei denen innerhalb eines einzigen Gerätes ein Flüssigkeits-Massenflusscontroller, ein Verdampfer und ein Mischer, in dem das Trägergas und gasförmiges Fluid gemischt werden, angeordnet sind. Das europäische Patent EP 0 559 259 B1 sowie dessen deutsche Übersetzung DE 693 16 409 T2 beschreiben ein solches Dosiersystem. Experimentelle Fluide enthalten teilweise Verunreinigungen, welche Ablagerungen in Gasversorgungssystem hinterlassen und zu Störungen führen können. Auch produktiv genutzte Fluide enthalten mitunter Reste von Verunreinigungen, die summarisch nach einem großen Fluiddurchsatz zu Ablagerungen in dem Flüssigkeits-Dosiersystem führen und aufwendige und teure Wartungsarbeiten und Produktionsunterbrechungen erforderlich machen.

Es ist deshalb die Aufgabe der vorliegenden Erfindung, ein Gasversorgungssystem vorzuschlagen, das lange Betriebszeiten zwischen Wartungsarbeiten, niedrige Wartungskosten sowie eine stabile Gasversorgung ermöglicht.

Die Aufgabe der Erfindung wird durch ein Gasversorgungssystem mit den angegebenen Merkmalen gelöst, bei welchem das Gasversorgungssystem in der Fluidflussrichtung zunächst den Massenflusscontroller für Flüssigkeiten, dann eine erste beheizbare Gasleitung und anschließend den Verdampfer und die Mischvorrichtung aufweist.

Das für einen Prozess zu dosierende Fluid durchläuft also mehrere hintereinander angeordnete Komponenten des Gasversorgungssystems, statt wie im Stand der Technik in einer kombinierten Vorrichtung dosiert und gemischt zu werden. In dem erfindungsgemäßen Gasversorgungssystem können verschiedene wichtige Parameter voneinander entkoppelt eingestellt werden. Mit dem Massenflusscontroller für Flüssigkeiten kann der Fluss des noch flüssigen Fluides, präzise dosiert werden, bevor es in den gasförmigen Aggregatzustand überführt wird. Die sich an den Massenflusscontroller anschließende Fluidleitung ist die erste Gasleitung, in welcher das allmählich verdunstende Fluid strömt. Die erste Gasleitung enthält keine Blenden oder sonstige Engstellen, die mit dem Risiko des Zusetzens behaftet wären. Außerdem ist diese Gasleitung beheizbar, sodass das Fluid vor dem Eintritt in den Verdampfer bereits vorgeheizt werden kann. Folglich kann das Fluid bereits in der beheizbaren ersten Gasleitung verdunsten bzw. teilweise verdampfen. Mit der Heizung der ersten Gasleitung können Temperaturen definiert eingestellt werden. Dies hat den Effekt stabilerer Fluid-Gasflüsse als bei Verwendung herkömmlicher Gasversorgungssysteme. Als Heizung kommt beispielsweise eine universelle Heizdecke oder eine speziell geformte Heizverkleidung zum Einsatz. Temperatursensoren, die einer Steuereinheit Temperaturwerte für die Regelung der Heizleistung liefern, können in die Heizung integriert oder zwischen der Heizung und dem beheizten Rohr montiert sein. In dem Verdampfer, der in der Flussrichtung des Fluides hinter der ersten Gasleitung angeordnet ist, wird durch eine ausreichend hohe Temperatur das Fluid vollständig verdampft. Die Mischvorrichtung ist der Teil des Gasversorgungssystems, in welchem ein Fluid-Gasstrom und ein Trägergasstrom zusammengeführt werden. Da Gasmoleküle gut beweglich sind, folgen sie nicht streng definiert einem vereinfacht angenommenen Gasstrom, sondern es kann auch zu einer Diffusion entgegen dem nominellen Gasstrom kommen. Diese Rückdiffusion ist in dem erfindungsgemäßen Gasversorgungssystem oftmals zulässig. Durch die Rückdiffusion kann das Gas in dem Verdampfer und in der ersten Gasleitung neben dem gasförmigen Fluid auch rückdiffundiertes Trägergas enthalten, sodass diese Bereiche schon geringfügig an der Durchmischung von Fluid-Gas und Trägergas beteiligt sein können. Falls die Rückdiffusion vermieden werden soll, dann kann die Fließgeschwindigkeit in der Fluidleitung zumindest abschnittweise größer als Diffusionsgeschwindigkeiten eingestellt werden.

Die Mischvorrichtung kann eine von dem Verdampfer separierbare Gasleitungszusammenführung von einer Fluidgasleitung und einer Trägergasleitung in eine Mischgasleitung sein. Die Fluidgasleitung ist dabei die Quelle des Fluides, die Trägergasleitung die Quelle des Trägergases und die Mischgasleitung die Senke des Gasgemisches von Fluid und Trägergas. Als Mischvorrichtung kann beispielsweise eine Tförmige oder Y-förmige Leitungsverzweigung eingesetzt werden. Es sind aber auch andere geometrische Anordnungen, beispielsweise symmetrische Düsenanordnungen möglich. Die Mischvorrichtung kann flussabwärts des Verdampfers angeordnet sein. Der Verdampfer und die Mischvorrichtung können aber auch eine kombinierte Vorrichtung sein.

In die Mischgasleitung kann außerdem eine in Flussrichtung nach der Gasleitungszusammenführung angeordnete Homogenisier-Vorrichtung eingebunden sein. Das von dem Gasversorgungssystem bereitgestellte Fluid-Trägergas-Gemisch soll möglichst homogen an dem Verbrauchsort des Fluides, beispielsweise in einer Prozesskammer einer Beschichtungsanlage bereitgestellt werden. Mit der Mischvorrichtung und der Homogenisier-Vorrichtung kann die Homogenität entsprechend den konkreten Anforderungen perfektioniert werden. Die Homogenisier-Vorrichtung kann einen spiralförmig geführten Mischraum aufweisen, wobei das Gasgemisch der spiralförmigen Leitungsführung folgt und sich infolge der mehrfachen Richtungswechsel gut durchmischt.

Die beheizbare erste Gasleitung kann mit einer auf eine Solltemperatur regelbaren Heizung gekoppelt sein, wobei die Solltemperatur so vorgebbar ist, dass bei dem in der Gasleitung anliegenden Druck eine Verdampfung des Fluides erfolgen kann. Bei der Änderung des Aggregatszustands des Fluides sind der Druck und die Temperatur zwei wesentliche Parameter. Die beheizbare erste Gasleitung ist innerhalb des erfindungsgemäßen Gasversorgungssystems der erste Leitungsabschnitt, in dem das Fluid teilweise gasförmig vorliegt. Die Verdunstung in diesem Bereich kann durch einen geringeren Druck als in einem vorhergehenden Leitungsabschnitt bewirkt werden. Mit der Verdunstung des Fluides in diesem Leitungsabschnitt ist das Auftreten von Verdunstungskälte verbunden, wobei dabei ein druckabhängiger und flussabhängiger Kühleffekt auftritt. An der beheizbaren ersten Gasleitung kann die für die Verdunstung benötigte Wärmeenergie von einer Heizung zugeführt werden, sodass das Fluid temperiert wird und Prozessschwankungen infolge von Temperaturschwankungen an der ersten Gasleitung vermieden werden können. Oftmals ist der geringere Druck ein Unterdruck oder ein Vakuum gegenüber atmosphärischen Druck, wobei der subatmosphärische Druck von einer Vakuumpumpe bereitgestellt wird. Das flüssige Fluid kann mit einem gegenüber atmosphärischen Druck erhöhten Druck bereitgestellt werden, wobei der erhöhte Druck beispielsweise von einer Pumpe oder einem Gasballast erzeugt werden kann. Je nach verwendetem Fluid kann auch eine Kühlung an einem Fluidleitungsabschnitt vorgesehen sein. Das erfindungsgemäße Gasversorgungssystem kann auch für die Gasversorgung bei Normaldruck oder Überdruck ausgebildet sein, wobei dann der Niederdruckbereich des Gasversorgungssystems entsprechend auf einem höheren Druckniveau liegt als bei einem Gasversorgungssystem für einen Vakuumprozess.

In dem erfindungsgemäßen Gasversorgungssystem können in der Fluidflussrichtung nach dem Massenflusscontroller alle Gasleitungen beheizbar sein, wobei die Temperatur entlang der Flussrichtung auf konstante und/oder ansteigende Temperaturen regelbar ist. Nach dem Verdampfer soll es zu keiner Verflüssigung des Fluides mehr kommen. Entsprechend werden kalte Punkte, an denen eine Kondensation auftreten könnte, vermieden. Bei einer Temperatur deutlich über der Kondensationstemperatur ist das Gasversorgungssystem unempfindlich gegenüber mit Toleranzen montierten Heizungen und dergleichen Abweichungen. Für die eingestellte Temperatur existieren auch obere Grenzen, die sich beispielsweise aus einer begrenzten Temperaturbeständigkeit des Fluides selbst oder aus begrenzten Temperaturbeständigkeiten von Komponenten des Gasversorgungssystems, z.B. Elastomerdichtungen, ergibt.

Gemäß einer Ausgestaltung des erfindungsgemäßen Gasversorgungssystems weist dieses einen Flüssigkeitsfilter und zwei Drucksensoren zur Messung eines über dem Flüssigkeitsfilter abfallenden Differenzdruckes beim Fließen des Fluides durch den Flüssigkeitsfilter auf. Mit dem Flüssigkeitsfilter können Verunreinigungen von dem Fluid abgetrennt werden. Über eine Filterüberwachung per Differenzdruckmessung kann ein zugesetzter Filter als Fehlerquelle verhindert werden. Außerdem kann der Massenflusscontroller für Flüssigkeiten zur Ausgabe einer Temperatur und einer Dichte des durch den Massenflusscontroller fließenden Fluides ausgebildet sein. Somit kann mit dem Massenflusscontroller nicht nur der Massenfluss des Fluides dosiert werden, sondern es kann zusätzlich eine Analyse des Fluides auf eine normgerechte Dichte erfolgen. Dadurch kann das Vorhandensein von Gasbläschen als eine Fehlerquelle ausgeschlossen werden.

Die Aufgabe der vorliegenden Erfindung wird auch durch ein Gasversorgungsverfahren mit einem erfindungsgemäßen Gasversorgungssystem gelöst. Dabei wird in dem Gasversorgungsverfahren in einer Fluidflussrichtung der Fluss flüssigen Fluides von einem Massenflusscontroller für Flüssigkeiten geregelt, das Fluid wird verdampft und mit einem Trägergas gemischt, um mit einem Trägergas gemischtes verdampftes Fluid beispielsweise in eine Prozesskammer zu liefern, dabei wird das Fluid in der Fluidflussrichtung zunächst durch den Massenflusscontroller, dann durch eine erste beheizbare Gasleitung und dann durch den Verdampfer und die Mischvorrichtung geleitet. Bei diesem Verfahren wird das gasförmige Fluid durch ausreichend große Leitungsquerschnitte geführt, in denen keine Verstopfungen auftreten. Die Temperaturen werden entlang des gesamten Flussweges gut kontrolliert, sodass eine stabile Gasversorgung auch bei unterschiedlichen Flüssen und Schaltvorgängen des Gasflusses gewährleistet wird.

Die vorliegende Erfindung wurde unter Angabe verschiedener Optionen beschrieben. Die Offenbarung umfasst außer konkret angegeben Merkmalskombinationen auch nicht explizit ausgeführte Merkmalskombinationen. Zufällig nacheinander beschriebene Merkmale dürfen nicht als zwingende Merkmalskombination fehlinterpretiert werden.

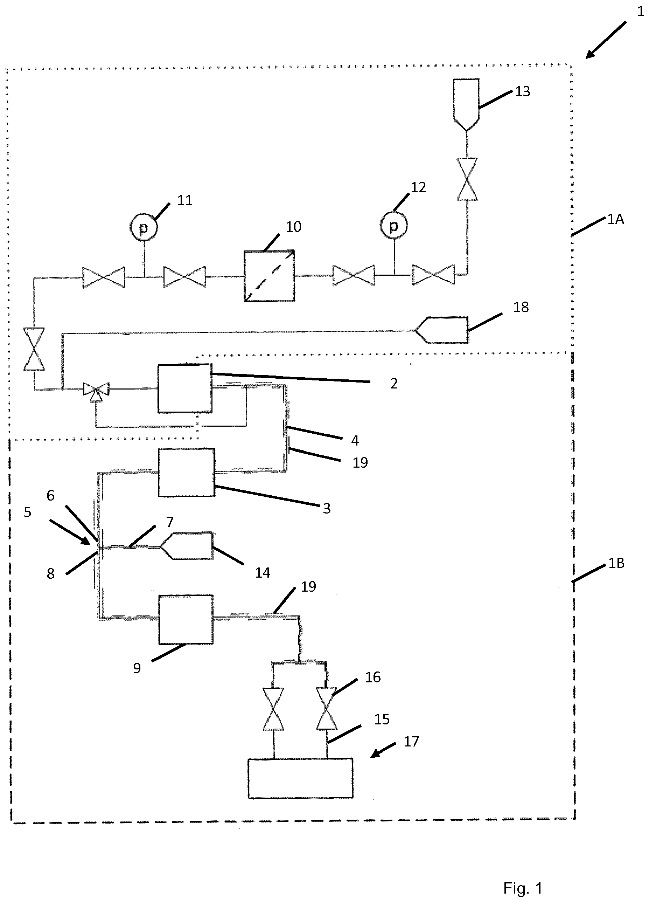

Die Erfindung soll im Folgenden anhand eines Ausführungsbeispiels erläutert werden, dabei zeigt
- Fig. 1: den Gaslaufplan eines erfindungsgemäßen Gasversorgungssystems.

Figur 1 stellt schematisch den Gaslaufplan eines Gaskabinetts als ein Ausführungsbeispiel eines erfindungsgemäßen Gasversorgungssystems 1 vor, wobei dieses am Beispiel der Bereitstellung von Trimethylaluminium-(TMA)-Dampf beschrieben wird. TMA - ist ein unter Normalbedingungen flüssiger Precursor, der bei Gasphasenabscheidungen beispielsweise von Aluminiumnitridschichten oder aluminiumhaltigen Verbindungshalbleiterschichten verwendet wird. Die Fluidflussrichtung des TMA erfolgt in Fig. 1 bei überblickartiger Betrachtung von oben nach unten. Dabei kann das Gasversorgungssystem 1 in einen Flüssigkeitsbereich 1A des Gasversorgungssystems 1 und in den Niederdruckbereich 1B des Gasversorgungssystems unterteilt werden. Im Flüssigkeitsbereich 1A liegt das Fluid, hier TMA, im flüssigen Aggregatszustand vor. Im Niederdruckbereich 1B des Gasversorgungssystems 1 erfolgt die Verdampfung des Fluides und dieses liegt, anfangs teilweise und später vollständig, im gasförmigen Aggregatzustand vor. Im vorliegenden Ausführungsbeispiel ist der Niederdruckbereich des vorgestellten Gaskabinetts für Prozessbedingungen im Hoch- oder Feinvakuum vorgesehen. Unter Niederdruck kann hier einen Druck kleiner 100 mbar verstanden werden. Das flüssige TMA wird von der schematisch dargestellten Quelle des flüssigen Fluides 13 bereitgestellt. Die Quelle des flüssigen Fluides 13 ist konkret eine von einem Vorratsbehälter ausgehende Zuleitung. Die Quelle des flüssigen Fluides 13 kann in einer experimentellen Anordnung auch eine direkt im Gaskabinett stehende, das TMA enthaltene Flasche sein. Die von der Quelle des flüssigen Fluides 13 abgehende Fluid-Leitung ist mit verschiedenen Ventilen in Abschnitte aufgeteilt, wobei die Ventile abschnittsweise Wartungs- und Überprüfungsarbeiten ermöglichen. Beispielsweise wird zum Tausch des TMA-Vorratsbehälters das erste Ventil in der Fluid Leitung geschlossen. In dem Gasversorgungssystem 1 fließt das TMA in flüssiger Form durch den Flüssigkeitsfilter 10 in den Massenflusscontroller für Flüssigkeiten 2, wo der Fluss des TMA für bestehende Prozessanforderungen dosiert werden kann.

Am Ausgang des Massenflusscontrollers beginnt der Niederdruckbereich des Gasversorgungssystems. In diesem Bereich erfolgt durch einen Unterdruck und eine erhöhte Temperatur eine teilweise Verdampfung bzw. Verdunstung des TMA. Bei der Verdunstung wird der flüssige TMA-Anteil durch Verdunstungskälte gekühlt. Bei niedrigeren Temperaturen verdunstet eine Flüssigkeit langsamer als bei höheren Temperaturen. Im Rahmen der vorliegenden Erfindung ist die erste Gasleitung 4 im Niederdruckbereich 1B, die sich flussabwärts an den Massenflusscontroller 2 für Flüssigkeiten anschließt, beheizbar. Durch eine Beheizung dieser Leitung kann die für die Verdunstung benötigte Wärme bereitgestellt und das Fluid temperiert in den Verdampfer eingeleitet werden. Dies führt letztlich zu einer sehr stabilen, von Prozessparameter-Schwankungen unabhängigen TMA Dampfversorgung. In dem konkreten Ausführungsbeispiel wird die Temperatur der ersten Gasleitung 4 auf eine Temperatur zwischen 38 und 42 °C eingestellt, vorzugsweise auf 40 ± 0,5 °C. Allgemein kann die Temperatur hier etwa 35° unter der Verdampfertemperatur liegen. Die erste Gasleitung 4 mündet in den Verdampfer 3, wo das Fluid vollständig verdampft wird. Im konkreten Ausführungsbeispiel ist der Verdampfer auf eine Temperatur von 75 °C geregelt. Flussabwärts des Verdampfers 3 ist die Mischvorrichtung 5 angeordnet. Der TMA-Dampf wird über die Fluidgasleitung 6 in die Mischvorrichtung 5 eingeleitet und dort mit einem Trägergas, das über die Trägergasleitung 7 eingeleitet wird, gemischt und weiter über die Mischgasleitung 8 abgeführt. Bei dem Trägergas handelt es sich in dem vorgestellten Ausführungsbeispiel um Argon, welches von der hier schematisch dargestellten Quelle des Trägergases 14 bereitgestellt wird. Die Mischvorrichtung ist in dem vorliegenden Ausführungsbeispiel ein Leitungs-T-Stück. In dem Ausführungsbeispiel sind alle Fluid-Leitungen des Gaskabinetts 1/4" Edelstahlrohre, die unter Verwendung von VCR-Metalldichtungen lösbar miteinander verbunden sind. Die Fluid-Leitungen flussabwärts des Verdampfers 3 werden wie der Verdampfer 3 selbst auf 75 °C geheizt. Am Ausgang der Mischvorrichtung 5, also in der Mischgasleitung 8, ist das Gasgemisch von TMA und Ar noch nicht vollständig homogen vermischt. Deshalb ist der Mischvorrichtung 5 die Homogenisier-Vorrichtung 9 nachgeschaltet. Im konkreten Fall basiert die Homogenisier-Vorrichtung 9 auf einem spiralförmig verlaufenden Volumen, innerhalb dessen ein homogenes Gasgemisch von dem Trägergas und dem TMA gebildet wird. Vom Ausgang der Homogenisier-Vorrichtung 9 wird das Gemisch des Fluidgasgemisches über Kammerventile 16 an Ausgänge 15 zu Verbrauchern geleitet, wobei die Verbraucher schematisch angedeutete Prozesskammern 17 einer Beschichtungsanlage sind, wo das Fluid TMA zur Herstellung aluminiumhaltiger Schichten verwendet wird.

Das erfindungsgemäße Gasversorgungssystem zeichnet sich durch eine hohe Betriebssicherheit aus und ist für den Einsatz in produktiven Umgebungen geeignet. Das Gasversorgungssystem weist Überwachungsvorrichtungen auf, beispielsweise den dargestellten Drucksensor 12 vor dem Flüssigkeitsfilter 10 und den Drucksensor 11 nach dem Flüssigkeitsfilter 10. Aus der Differenz der von den beiden Drucksensoren 11,12 gelieferten Werte kann der Flusswiderstand des Flüssigkeitsfilters ermittelt werden. In Reaktion auf einen Anstieg der Druckdifferenz kann rechtzeitig vor dem Zusetzen des Flüssigkeitsfilters 10 ein Wechsel desselben veranlasst werden. Weitere, nicht dargestellte Überwachungsvorrichtungen, ermitteln die Temperatur und die Dichte des TMA im Massenflusscontroller für Flüssigkeiten 2. Das Gasversorgungssystem kann weitere Komponenten enthalten, als Beispiel ist hier die Spülgasquelle 18 schematisch skizziert.

### Bezugszeichen

- 1: Gasversorgungssystem
- 2: Massenflusscontroller für Flüssigkeiten
- 3: Verdampfer
- 4: erste beheizbare Gasleitung
- 5: Mischvorrichtung
- 6: Fluidgasleitung
- 7: Trägergasleitung
- 8: Mischgasleitung
- 9: Homogenisierungs-Vorrichtung
- 10: Flüssigkeitsfilter
- 11: Drucksensor nach Flüssigkeitsfilter
- 12: Drucksensor vor Flüssigkeitsfilter
- 13: Quelle des flüssigen Fluides
- 14: Quelle des Trägergases
- 15: Ausgang zum Gasverbraucher
- 16: Kammerventil
- 17: Prozesskammer
- 18: Spülgasquelle
- 19: Heizung für Gasleitung
- 1A: Flüssigkeitsbereich des Gasversorgungssystems
- 1 B: Niederdruckbereich des Gasversorgungssystems

## Patentansprüche

1. Gasversorgungssystem (1) mit einem Massenflusscontroller (2) für Flüssigkeiten, Flüssigkeitsleitungen, einem Verdampfer (3) zur Überführung eines Fluides von dem flüssigen in den gasförmigen Aggregatzustand insbesondere bei subatmosphärischen Druck, Gasleitungen, sowie einer Mischvorrichtung zur Mischung des in einer Fluidflussrichtung fließenden Fluides mit einem Trägergas, **dadurch gekennzeichnet, dass** das Gasversorgungssystem (1) in der Fluidflussrichtung zunächst den Massenflusscontroller (2), dann eine erste beheizbare Gasleitung (4) und anschließend den Verdampfer (3) und die Mischvorrichtung (5) aufweist.

2. Gasversorgungssystem (1) nach Anspruch 1, **dadurch gekennzeichnet, dass** die Mischvorrichtung (5) als eine von dem Verdampfer (3) separierbare Gasleitungszusammenführung von einer Fluidgasleitung (6) und einer Trägergasleitung (7) in eine Mischgasleitung (8) ausgebildet ist.

3. Gasversorgungssystem (1) nach Anspruch 1 oder 2, **dadurch gekennzeichnet, dass** in die Mischgasleitung (8) außerdem eine in Flussrichtung nach der Gasleitungszusammenführung angeordnete Homogenisierungs-Vorrichtung (9) eingebunden ist.

4. Gasversorgungssystem (1) nach Anspruch 3, **dadurch gekennzeichnet, dass** die Homogenisier-Vorrichtung (9) einen spiralförmig geführten Mischraum aufweist.

5. Gasversorgungssystem (1) nach wenigstens einem der vorhergehenden Ansprüche, **dadurch gekennzeichnet, dass** die erste beheizbare Gasleitung (4) mit einer auf eine Solltemperatur regelbaren Heizung (19) gekoppelt ist, wobei die Solltemperatur so vorgebbar ist, dass bei dem in der ersten Gasleitung (4) anliegenden Druck eine Verdunstung des Fluides steuerbar ist.

6. Gasversorgungssystem (1) nach wenigstens einem der vorhergehenden Ansprüche, **dadurch gekennzeichnet, dass** in der Fluidflussrichtung nach dem Massenflusscontroller (3) alle Gasleitungen beheizbar sind, wobei die Temperaturen entlang der Flussrichtung auf konstante und/oder ansteigende Temperaturwerte regelbar ist.

7. Gasversorgungssystem (1) nach wenigstens einem der vorhergehenden Ansprüche, **dadurch gekennzeichnet, dass** das Gasversorgungssystem (1) einen Flüssigkeitsfilter (10) und zwei Drucksensoren (11, 12) zur Messung eines über dem Flüssigkeitsfilter (10) abfallenden Differenzdruckes beim Fließen des Fluides durch den Flüssigkeitsfilter (10) aufweist.

8. Gasversorgungssystem (1) nach wenigstens einem der vorhergehenden Ansprüche, **dadurch gekennzeichnet, dass** der Massenflusscontroller (2) für Flüssigkeiten zur Ausgabe einer Temperatur und einer Dichte des durch den Massenflusscontroller (2) fließenden Fluides ausgebildet ist.

9. Gasversorgungsverfahren mit einem Gasversorgungssystem (1) nach wenigstens einem der Ansprüche 1 bis 8, wobei in dem Gasversorgungsverfahren in einer Fluidflussrichtung der Fluss flüssigen Fluides von einem Massenflusscontroller (2) für Flüssigkeiten geregelt wird und das Fluid verdampft und mit einem Trägergas gemischt wird um mit einem Trägergas gemischtes verdampftes Fluid zu liefern, **dadurch gekennzeichnet, dass** das Fluid in der Fluidflussrichtung zunächst durch den Massenflusscontroller (2), dann durch eine erste beheizbare Gasleitung (4) und dann durch den Verdampfer (3) und eine Mischvorrichtung (5) geleitet wird.
